# FASCICULE DE BREVET EUROPEEN

(11) **EP 3 413 473 B1**
(45) Date de publication et mention de la délivrance du brevet: **01.12.2021**
(21) Numéro de dépôt: 18174551.4
(22) Date de dépôt: 28.05.2018
(51) Int. Cl.: H04B 5/00, H04W 52/00

(54) **PROCÉDÉ DE CONTRÔLE DU NIVEAU DE PUISSANCE ÉMISE PAR UN DISPOSITIF DE COMMUNICATION SANS CONTACT, PAR EXEMPLE UN LECTEUR, ET DISPOSITIF DE COMMUNICATION SANS CONTACT CORRESPONDANT**
KONTROLLVERFAHREN DES NIVEAUS DER VON EINER KONTAKTLOSEN KOMMUNIKATIONSVORRICHTUNG GELIEFERTEN LEISTUNG, BEISPIELSWEISE EINEM LESEGERÄT, UND ENTSPRECHENDE KONTAKTLOSE KOMMUNIKATIONSVORRICHTUNG
METHOD FOR CONTROLLING THE LEVEL OF POWER EMITTED BY A CONTACTLESS COMMUNICATION DEVICE, FOR EXAMPLE, A READER, AND CORRESPONDING CONTACTLESS COMMUNICATION DEVICE

(30) Priorité: 09.06.2017 FR 1755163
(43) Date de publication de la demande: 12.12.2018
(73) Titulaire: STMicroelectronics (Rousset) SAS, 13790 Rousset (FR); STMicroelectronics razvoj polprevodnikov d.o.o., 1000 Ljubljana (SI)
(72) Inventeur: TRAMONI, Alexandre, 83330 Le Beausset (FR); CORDIER, Nicolas, 13080 Luynes (FR); STIGLIC, Maksimiljan, 2000 MARIBOR (SI)
(74) Mandataire: Casalonga

(56) Documents cités:
- US-A1- 2005 156 669
- US-A1- 2013 084 799

## Description

Des modes de mise en œuvre et de réalisation de l'invention concernent la communication sans fil ou sans contact utilisant des composants électroniques connectés à une antenne, notamment des composants configurés pour échanger des informations avec un dispositif externe via ladite antenne selon un protocole de communication du type sans contact et plus particulièrement le contrôle de la puissance émise par l'antenne.

L'antenne d'un tel composant est accordée sur une fréquence compatible avec une communication sans contact des informations. Une telle fréquence peut être par exemple une fréquence de résonance égale à une fréquence de porteuse, par exemple 13,56 MHz, ou bien une fréquence de résonance contenue dans une plage admissible autour de la fréquence de porteuse.

De tels composants sont plus simplement appelés, par abus de langage « composants sans contact » et peuvent être par exemple des composants dits « NFC », c'est-à-dire des composants compatibles avec la technologie NFC (« Near Field Communication »).

Le composant NFC peut être par exemple un circuit intégré ou puce, incorporant un microcontrôleur NFC.

L'acronyme NFC (« Near Field Communication ») désigne une technologie de communication sans fil haute fréquence faible distance, qui permet des échanges de données entre deux dispositifs sans contact sur une faible distance, par exemple 10 cm.

La technologie NFC est normalisée dans les documents ISO/IEC 18 092, ISO/IEC 21 481 et NFC FORUM mais incorpore une variété de normes préexistantes incluant les protocoles type A et type B de la norme ISO/IEC 14 443.

Un composant NFC peut être généralement utilisé soit en mode « lecteur » ou en mode « carte », pour dialoguer avec un autre dispositif sans contact, par exemple en utilisant un protocole de communication sans contact tel que le protocole type A de la norme ISO/IEC 14 443.

Dans le mode « lecteur », le composant NFC agit comme un lecteur vis-à-vis du dispositif externe sans contact qui peut être alors une carte ou bien une étiquette. Dans le mode lecteur, le composant NFC peut alors lire le contenu du dispositif externe et écrire des informations dans le dispositif externe.

Dans le mode « carte », le composant NFC se comporte alors comme un transpondeur, par exemple une carte ou une étiquette, et dialogue avec le dispositif externe qui est cette fois-ci un lecteur.

Le transpondeur peut-être passif ou actif.

Un transpondeur passif effectue une modulation de charge du champ magnétique généré par le lecteur.

Un transpondeur actif utilise une modulation active de charge (également connue par l'homme du métier sous son acronyme anglo-saxon ALM : « Active Load Modulation ») pour transmettre les informations vers le lecteur. Le transpondeur génère également un champ magnétique par l'intermédiaire de son antenne qui simule la modulation de charge du champ du lecteur effectuée par un transpondeur passif.

La modulation active de charge est avantageusement utilisée lorsque le signal résultant d'une modulation passive de charge n'est pas assez fort pour être détecté par le lecteur. C'est notamment le cas lorsque l'antenne du transpondeur est petite ou situé dans un environnement défavorable.

Un composant ou puce NFC peut être par exemple incorporé dans un téléphone mobile cellulaire, et ce dernier peut être utilisé alors, outre sa fonction téléphonique classique, pour échanger des informations avec le dispositif externe sans contact.

De nombreuses applications sont ainsi possibles, telles que le franchissement de barrière de péage dans les transports (le téléphone mobile agit comme ticket de transport) ou bien des applications de paiement (le téléphone mobile agit comme carte de crédit).

Des modes de mise en œuvre et de réalisation de l'invention concernent les lecteurs sans contact ou les transpondeurs actifs, c'est-à-dire utilisant une modulation active de charge. De tels lecteurs peuvent être des appareils spécifiques ou bien des dispositifs ou composants sans contact émulés en mode lecteur, par exemple incorporés dans des appareils hôtes tels que par exemple des téléphones mobiles cellulaires ou des tablettes.

De même de tels transpondeurs actifs peuvent être des dispositifs spécifiques, par exemple des cartes à puces sans contact, des étiquettes ou des badges, ou bien des dispositifs ou composants sans contact émulés en mode carte, là encore par exemple incorporés dans des appareils hôtes tels que par exemple des téléphones mobiles cellulaires ou des tablettes.

Les composants ou puces sans contact, tels que les composants ou puces NFC, sont généralement connectés à l'antenne par l'intermédiaire d'un circuit d'adaptation d'impédance dans le but d'optimiser la communication radiofréquence. Et, les éléments utilisés dans ce circuit d'adaptation d'impédance par exemple des bobines et des condensateurs, sont dimensionnés, de façon à permettre un bon accord fréquentiel de l'antenne, par exemple sur une fréquence de porteuse, (par exemple 13,56 MHz), et assurer ainsi le maximum de performance.

Par ailleurs un composant ou puce sans contact, comporte généralement des moyens de pilotage de l'antenne, connectés aux bornes de l'antenne par l'intermédiaire du circuit d'adaptation d'impédance, et permettant de faire circuler dans l'antenne un courant ayant la fréquence porteuse considérée (par exemple 13,56 MHz) de façon à générer le champ électromagnétique.

Ces moyens de pilotage comportent généralement des circuits de pilotage (communément désignés par l'homme du métier sous le vocable anglais« drivers ») préférentiellement alimentés en tension par l'intermédiaire d'un régulateur à faible chute de tension, communément désigné par l'homme du métier sous la dénomination anglo-saxonne LDO (« Low Drop Out Voltage »).

Pour des raisons d'interopérabilité, les normes de communication sans contact, par exemple la norme NFC FORUM, imposent que le transfert de puissance entre un lecteur et un transpondeur soit compris dans une certaine plage de puissances.

Le document US2005/156669A1 décrit un dispositif de commande de la puissance de transmission dans un appareil de communication radio. Le dispositif de commande ajuste la puissance de transmission à une valeur cible prédéterminée en amplifiant la puissance d'un signal de transmission à l'aide d'un premier amplificateur (amplificateur de pilotage) et d'un second amplificateur (amplificateur de puissance) dont l'entrée est connectée à la sortie du premier amplificateur. Des moyens de commande commandent le gain du premier amplificateur sur la base d'un courant électrique qui circule depuis une source d'alimentation vers le second amplificateur.

Lorsque la puissance émise à travers l'antenne d'un lecteur ou d'un transpondeur actif dépasse la plage de puissances mentionnée ci-avant, par exemple lorsque le lecteur et le transpondeur sont trop proches, un contrôle dynamique de puissance (DPC : « Dynamic Power Control ») est mis en œuvre pour réduire cette puissance émise.

Cette réduction de puissance peut être également requise par le transpondeur lui-même par l'envoi d'une requête spécifique au lecteur, lorsque le transpondeur supporte cette fonctionnalité qui est prévue dans l'amendement DPLM (« Dynamic Power Level Management ») de la norme ISO/IEC 14 443.

Les inventeurs ont alors observé qu'une telle réduction de puissance se traduit par une dissipation thermique au niveau des circuits de pilotage et/ou du régulateur à faible chute de tension.

Or dans certains cas réchauffement thermique de ces éléments peut leur être préjudiciable si la température atteinte se situe en dehors de la plage de températures dans laquelle ils sont conçus pour fonctionner correctement.

Il existe donc un besoin de limiter l'échauffement thermique de ces éléments lors d'une diminution de la puissance émise par l'antenne, de façon à rester dans la plage de températures acceptable pour ces éléments.

Selon un mode de mise en œuvre et de réalisation les inventeurs ont observé qu'il est possible de répondre à ce besoin en agissant directement sur la tension d'alimentation des moyens de pilotage, de façon à la réduire, au lieu d'agir sur des caractéristiques intrinsèques de ces moyens de pilotage (par exemple la réduction de la tension de sortie du régulateur et/ou l'augmentation de la résistance ohmique des circuits de pilotage (drivers).

A cet égard bien qu'il soit préférable que les moyens de pilotage comportent un régulateur du type LDO, notamment pour filtrer le bruit, celui-ci n'est toutefois pas indispensable. Aussi si les moyens de pilotage ne comportent pas de régulateur, on agit alors directement sur la tension d'alimentation des circuits de pilotage, tandis que si les circuits de pilotage sont alimentés en tension par un régulateur, on agit sur la tension d'alimentation du régulateur.

Selon un aspect il est proposé un procédé de contrôle du niveau de la puissance émise par une antenne d'un dispositif de communication sans contact.

Ladite antenne est pilotée par des moyens de pilotage alimentés par une tension d'alimentation et configurés pour délivrer en sortie un courant à destination de l'antenne.

Le dispositif de communication sans contact peut comporter une puce électronique (incorporant notamment les moyens de pilotage et au moins une partie des moyens de contrôle du niveau de puissance) à laquelle est connectée l'antenne, généralement par l'intermédiaire notamment d'un circuit d'adaptation d'impédance, et ce dispositif de communication sans contact peut être un lecteur ou un transpondeur actif. Il peut avoir aussi la capacité d'être émulé en mode lecteur ou mode carte en étant par exemple incorporé au sein d'un appareil hôte, tel qu'un téléphone mobile cellulaire intelligent (« smartphone ») ou une tablette.

Lorsqu'il est couplé à un autre dispositif de communication sans contact, les deux dispositifs peuvent échanger des informations selon par exemple un protocole de communication sans contact, tel que celui décrit dans la norme ISO/IEC 14443.

Le procédé selon cet aspect comprend en présence d'une requête de diminution d'un niveau actuel de ladite puissance émise, une diminution de la tension d'alimentation des moyens de pilotage jusqu'à une valeur cible correspondant à un nouveau niveau cible de ladite puissance émise inférieur audit niveau actuel.

Ce nouveau niveau cible de puissance peut être un niveau inférieur ou égal à un seuil de puissance admissible, si par exemple le niveau actuel est supérieur à ce seuil de puissance admissible.

Ce seuil de puissance admissible dépend par exemple des conditions d'utilisation du dispositif de communication sans contact, en particulier de ces conditions de couplage avec un autre dispositif de communication sans contact.

Ce seuil peut être fixé par une norme régissant le protocole de communication sans contact mis en œuvre par le dispositif de communication sans contact, par exemple la norme ISO/IEC 14 443.

En variante, la requête de diminution du niveau de puissance actuel peut intervenir même si ce niveau de puissance actuel n'est pas supérieur au seuil de puissance admissible.

Ainsi dans les systèmes DPLM, il est possible que le transpondeur requiert une diminution du niveau actuel de puissance émise par le lecteur, même si ce niveau actuel est inférieur au seuil de puissance admissible, simplement pour réduire la consommation et ce car le transpondeur est capable de fonctionner à une puissance plus faible.

De même, dans le cas d'un transpondeur actif utilisant une modulation active de charge, le niveau actuel de puissance émise par le lecteur peut être réduit même s'il n'est pas supérieur à un seuil de puissance admissible, et ce pour fonctionner à un niveau cible de puissance inférieur, par exemple pour des raisons de stabilité de la communication et de meilleure inter-opérabilité avec des infrastructures existantes.

On peut définir une valeur maximale pour la tension d'alimentation correspondant à un niveau initial de puissance, et la diminution de puissance débute alors à partir de ladite valeur maximale de tension d'alimentation.

Ce niveau initial de puissance peut correspondre à un niveau de puissance émise en absence de couplage de ladite antenne avec une autre antenne d'un autre dispositif sans contact.

Selon un mode de mise en œuvre, les moyens de pilotage peuvent avantageusement comporter un régulateur à chute de tension, par exemple un régulateur à faible chute de tension, alimenté par ladite tension d'alimentation et délivrant une tension de sortie égale à ladite tension d'alimentation diminuée de ladite chute de tension, et des circuits de pilotage couplés aux bornes de l'antenne, alimentés par ladite tension de sortie et délivrant à leur sortie ledit courant, et la diminution de la tension des moyens de pilotage comprend une diminution de la tension d'alimentation du régulateur jusqu'à ladite valeur cible, ladite chute de tension étant inchangée.

Selon un mode particulièrement avantageux de mise en œuvre, on peut générer la tension d'alimentation de façon ajustable à partir d'une tension initiale, par exemple une tension issue d'une batterie, et d'un signal d'ajustement, et la diminution de ladite tension d'alimentation comprend une élaboration dudit signal d'ajustement de façon à permettre à ladite tension d'alimentation d'atteindre sa valeur cible.

Bien que l'on puisse générer la tension d'alimentation à partir de différents moyens, comme par exemple un régulateur à chute de tension programmable, ou un transistor PMOS, il est particulièrement avantageux, notamment pour limiter encore davantage la dissipation thermique, de générer la tension d'alimentation sur la sortie d'une alimentation à découpage pilotable (ou commandable) possédant une entrée recevant ladite tension initiale et une entrée de commande sur laquelle on délivre ledit signal d'ajustement.

Selon un mode de mise en œuvre, lorsque le dispositif de communication sans contact est un lecteur ou est émulé en mode lecteur, le procédé comprend par exemple une mesure du courant délivré en sortie des moyens de pilotage, une comparaison du courant mesuré à au moins un seuil de courant, le résultat de la comparaison correspondant soit à ladite présence de la requête de diminution de puissance émise soit à une absence de ladite requête.

Plus précisément, on peut par exemple définir un premier seuil de courant, correspondant par exemple à une absence de couplage de ladite antenne avec une autre antenne d'un transpondeur sans contact, et au moins un seuil de courant supplémentaire, supérieur au premier seuil, et dont le franchissement correspond à la présence d'une requête de diminution de niveau de puissance, et on peut associer à chaque seuil de courant supplémentaire une valeur du signal d'ajustement permettant à ladite tension d'alimentation d'atteindre une valeur cible conduisant à ramener le courant délivré en sortie des moyens de couplage à une valeur située entre le premier seuil de courant et le seuil de courant supplémentaire le plus faible.

Selon un autre mode de mise en œuvre possible, également applicable lorsque le dispositif de communication sans contact est un lecteur ou est émulé en mode lecteur, le procédé peut comprendre une mesure d'une tension et/ou de phase témoin en un endroit situé entre la sortie des moyens de pilotage et l'antenne, une comparaison de la tension et/ou de phase témoin à au moins un seuil de tension et/ou de phase, le résultat de la comparaison correspondant soit à ladite présence de la requête de diminution de niveau de puissance émise soit à une absence de ladite requête.

Là encore on peut définir un premier seuil de tension et/ou de phase, correspondant par exemple à une absence de couplage de ladite antenne avec une autre antenne d'un transpondeur sans contact, et au moins un seuil de tension et/ou de phase supplémentaire, inférieur au premier seuil, et dont le franchissement par la tension et/ou la phase témoin correspond à la présence d'une requête de diminution de niveau de puissance, et on associe à chaque seuil de tension et/ou de phase supplémentaire une valeur du signal d'ajustement permettant à ladite tension d'alimentation d'atteindre une valeur cible conduisant à ramener la tension et/ou la phase témoin à une valeur située entre le premier seuil de tension et/ou de phase et le seuil de tension et/ou de phase supplémentaire le plus élevé.

Selon un autre mode de mise en œuvre, lorsque le dispositif de communication sans contact est un transpondeur ou est émulé en mode carte capable de communiquer avec un lecteur selon une modulation active de charge, le procédé peut comprendre une définition de plusieurs niveaux de puissance émis par l'antenne du dispositif associés à plusieurs niveaux de puissance reçus par l'antenne du dispositif de la part du lecteur, une détection par le dispositif du niveau de puissance reçu, une augmentation du niveau de puissance reçu correspondant à ladite présence de la requête de diminution de niveau de puissance émise par l'antenne du dispositif.

On peut par exemple définir pour chaque niveau de puissance émis la valeur cible correspondante de ladite tension d'alimentation.

Ladite requête de diminution de puissance peut être générée par le dispositif de communication sans contact lui-même.

En variante, lorsque le dispositif de communication sans contact est un lecteur ou est émulé en mode lecteur, la requête de diminution de puissance peut être communiquée au lecteur par un transpondeur ou un autre dispositif de communication émulé en mode carte couplé au lecteur, et cette requête comporte une information indiquant la valeur de la diminution requise. Ceci est compatible avec l'amendement DPLM (« Dynamic Power Level Management ») de la norme ISO/IEC 14 443.

Ainsi à la réception de ladite requête de diminution de niveau de puissance, on peut générer au sein du lecteur ladite valeur cible de la tension d'alimentation.

Alors que l'on a évoqué ci-avant une ou plusieurs diminutions de niveau de puissance, il peut être prévu, selon un mode de mise en œuvre, lorsque la puissance émise atteint un seuil minimal admissible, d'augmenter la tension d'alimentation jusqu'à sa valeur maximale.

Selon un autre aspect, il est proposé un dispositif de communication sans contact, comprenant une antenne, des moyens de pilotage possédant une borne d'alimentation destinée à recevoir une tension d'alimentation et configurés pour délivrer un courant à destination de l'antenne, et des moyens de contrôle de la puissance émise par ladite antenne configurés pour, en présence d'une requête de diminution d'un niveau actuel de puissance émise, diminuer la tension d'alimentation des moyens de pilotage jusqu'à une valeur cible correspondant à un nouveau niveau cible de ladite puissance émise inférieur audit niveau actuel.

Selon un mode de réalisation, les moyens de pilotage comportent un régulateur à chute de tension possédant une borne d'entrée couplée à la borne d'alimentation et configuré pour délivrer sur sa borne de sortie une tension de sortie égale à ladite tension d'alimentation diminuée de ladite chute de tension, et des circuits de pilotage couplés aux bornes de l'antenne, destinés à être alimentés par ladite tension de sortie et configurés pour délivrer à leur sortie ledit courant, et les moyens de contrôle sont configurés pour diminuer la tension d'alimentation du régulateur jusqu'à ladite valeur cible, ladite chute de tension étant inchangée.

Selon un mode de réalisation, les moyens de contrôle comportent des moyens de génération configurés pour générer la tension d'alimentation de façon ajustable à partir d'une tension initiale et d'un signal d'ajustement, et des moyens d'élaboration configurés pour élaborer le signal d'ajustement de façon à permettre à ladite tension d'alimentation d'atteindre sa valeur cible.

Selon un mode de réalisation, les moyens de génération comportent une alimentation à découpage pilotable (ou commandable) possédant une entrée pour recevoir ladite tension initiale, une sortie pour délivrer ladite tension d'alimentation et une entrée de commande destinée à recevoir ledit signal d'ajustement.

Selon un mode de réalisation, le dispositif comprend une puce électronique incorporant les moyens de pilotage, les moyens d'élaboration et au moins une partie de l'alimentation à découpage.

Selon une variante de réalisation, le dispositif est un lecteur ou est émulé en mode lecteur, et les moyens de contrôle comportent des premiers moyens de mesure configurés pour effectuer une mesure du courant délivré en sortie des moyens de pilotage, des premiers moyens de comparaison configurés pour effectuer une comparaison du courant mesuré à au moins un seuil de courant, le résultat de la comparaison correspondant soit à ladite présence de la requête de diminution de niveau de puissance émise soit à une absence de ladite requête.

Selon un mode de réalisation de cette variante, les moyens de contrôle comportent des premiers moyens de mémoire configurés pour stocker un premier seuil de courant et au moins un seuil de courant supplémentaire, supérieur au premier seuil, et dont le franchissement correspond à la présence d'une requête de diminution de puissance, et les moyens d'élaboration sont configurés pour associer à chaque seuil de courant supplémentaire une valeur du signal d'ajustement permettant à ladite tension d'alimentation d'atteindre sa valeur cible de façon à ramener le courant délivré en sortie des moyens de couplage à une valeur située entre le premier seuil de courant et le seuil de courant supplémentaire le plus faible.

Selon une autre variante de réalisation, le dispositif est un lecteur ou est émulé en mode lecteur, et les moyens de contrôle comportent des deuxièmes moyens de mesure configurés pour effectuer une mesure d'une tension et/ou d'une phase témoin en un endroit situé entre la sortie des moyens de pilotage et l'antenne, des deuxièmes moyens de comparaison configurés pour effectuer une comparaison de la tension et/ou la phase témoin à au moins un seuil de tension et/ou de phase, le résultat de la comparaison correspondant soit à ladite présence de la requête de diminution de niveau de puissance émise soit à une absence de ladite requête.

Selon un mode de réalisation de cette autre variante, les moyens de contrôle comportent des deuxièmes moyens de mémoire configurés pour stocker un premier seuil de tension et/ou de phase et au moins un seuil de tension et/ou de phase supplémentaire, inférieur au premier seuil, et dont le franchissement par la tension et/ou la phase témoin correspond à la présence d'une requête de diminution de niveau de puissance, et les moyens d'élaboration sont configurés pour associer à chaque seuil de tension et/ou de phase supplémentaire une valeur du signal d'ajustement permettant à ladite tension d'alimentation d'atteindre sa valeur cible de façon à ramener la tension et/ou la phase témoin à une valeur située entre le premier seuil de tension et/ou de phase et le seuil de tension et/ou de phase supplémentaire le plus élevé.

Le premier seuil de courant ou le premier seuil de tension et/ou de phase peut correspondre à une absence de couplage de ladite antenne avec une autre antenne d'un transpondeur sans contact.

Selon une autre variante de réalisation, le dispositif est un transpondeur ou est émulé en mode carte capable de communiquer avec un lecteur selon une modulation active de charge, et les moyens de contrôle comportent des troisièmes moyens de mémoire configurés pour stocker plusieurs niveaux de puissance émis par l'antenne du dispositif associés à plusieurs niveaux de puissance reçus par l'antenne du dispositif de la part du lecteur, des moyens de détection configurés pour effectuer une détection du niveau de puissance reçu, une augmentation du niveau de puissance reçu correspondant à ladite présence de la requête de diminution de niveau de puissance émise par l'antenne du dispositif.

Selon un mode de réalisation de cette autre variante, les moyens de contrôle comportent des quatrièmes moyens de mémoire configurés pour stocker pour chaque niveau de puissance émis la valeur cible correspondante de ladite tension d'alimentation et les moyens d'élaboration sont configurés pour ajuster la valeur du signal d'ajustement en fonction de la valeur cible correspondante de la tension d'alimentation.

Selon un mode de réalisation possible, les moyens de contrôle sont configurés pour générer ladite requête de diminution de niveau de puissance.

En variante, lorsque le dispositif est un lecteur ou est émulé en mode lecteur, les moyens de contrôle sont configurés pour recevoir la requête de diminution de niveau de puissance de la part d'un transpondeur ou d'un autre dispositif de communication émulé en mode carte couplé audit dispositif, ladite requête comportant une information indiquant la valeur de la diminution de niveau requise.

Les moyens de contrôle sont alors avantageusement configurés pour générer ladite valeur cible de la tension d'alimentation à la réception de ladite requête de diminution de niveau de puissance.

Les moyens de contrôle sont avantageusement configurés pour débuter une diminution de niveau de puissance à partir d'une valeur maximale pour la tension d'alimentation correspondant à un niveau initial de puissance.

Ce niveau initial de puissance peut correspondre à un niveau de puissance émise en absence de couplage de ladite antenne avec une autre antenne d'un autre dispositif sans contact.

Selon un mode de réalisation, lorsque la puissance émise atteint un seuil minimal admissible, les moyens de contrôle sont configurés pour augmenter la tension d'alimentation jusqu'à sa valeur maximale.

Selon un autre aspect, il est proposé un appareil hôte, par exemple un appareil de communication sans fil, tel qu'un téléphone mobile cellulaire, incorporant un dispositif de communication sans contact tel que défini ci-avant.

D'autres avantages et caractéristiques de l'invention apparaîtront à la description détaillée de modes de réalisation et de mise en œuvre, nullement limitatifs, et des dessins annexés sur lesquels :

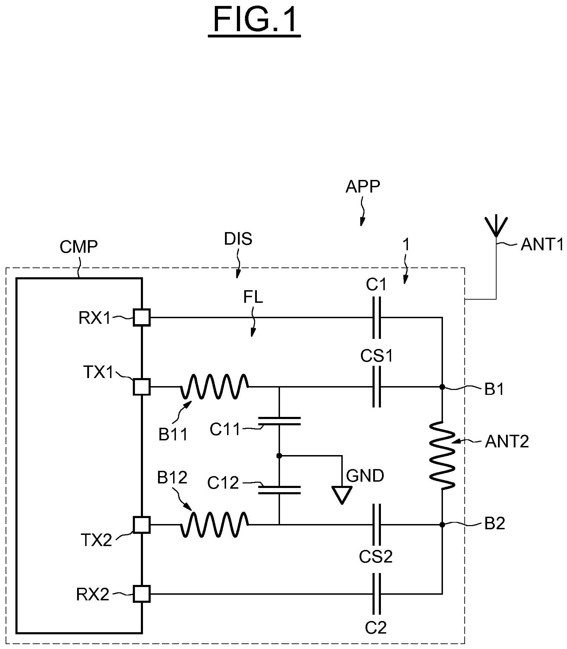

les figures 1 à 11 illustrent schématiquement différents modes de mise en œuvre et de réalisation de l'invention.

Sur la figure 1, la référence APP désigne un appareil de communication, par exemple un téléphone mobile cellulaire, équipé d'une antenne ANT1 pour l'établissement des communications téléphoniques.

Dans le cas présent, l'appareil APP comporte également un dispositif DIS de communication sans contact, par exemple du type NFC comportant une puce électronique CMP sans contact du type NFC.

On suppose ici que le dispositif DIS de communication sans contact est un lecteur ou émulé en mode lecteur.

La puce CMP possède de façon classique deux contacts TX1, TX2 et deux autres contacts RX1, RX2.

Une antenne ANT2, par exemple un enroulement inductif, est utilisable pour la communication sans contact avec un dispositif externe, par exemple un transpondeur. Une première borne B1 de cette antenne ANT2 est connectée aux contacts TX1 et RX1 tandis que la deuxième borne B2 de l'antenne ANT2 est connectée aux contacts TX2 et RX2.

Les contacts TX1 et TX2 forment une première et une deuxième bornes de sortie de la puce CMP pour l'émission de données vers l'antenne ANT2 tandis que les contacts RX1 et RX2 forment deux bornes d'entrée du composant pour la réception de données provenant de l'antenne ANT2.

Un circuit externe d'adaptation d'impédance est connecté entre l'antenne ANT2 et la puce CMP.

Plus précisément, de façon classique et connue en soi, ce circuit d'adaptation d'impédance peut comporter un filtre FL destiné à filtrer les interférences électromagnétiques (filtre EMI).

Ce filtre FL est classiquement un filtre du type LC comportant ici une bobine B11 connectée en série, entre le contact TX1 et la masse GND, avec un condensateur C11.

Le filtre FL comporte également une bobine B12 connectée en série, entre le contact TX2 et la masse GND, avec un condensateur C12.

Le filtre FL possède une fréquence de coupure (par exemple 20 MHz pour une fréquence de porteuse de 13,56 MHz).

Le circuit d'adaptation d'impédance comporte aussi un réseau capacitif 1 contenant les condensateurs C1, C2, CS1 et CS2.

Les condensateurs C1 et C2 forment un diviseur capacitif aux bornes des contacts RX1 et RX2.

Les condensateurs CS1 et CS2 sont quant à eux choisis pour maximiser le courant dans l'antenne ANT2 de façon à augmenter l'amplitude du champ électromagnétique.

De façon à avoir un fonctionnement optimisé, la puce ou composant CMP forme avec l'antenne ANT2 et le circuit externe de l'adaptation d'impédance un circuit résonant ayant une fréquence de résonance égale à la fréquence de porteuse, par exemple 13,56 MHz dans le cas d'un protocole de communication type A ou type B défini dans la norme ISO/IEC 14443.

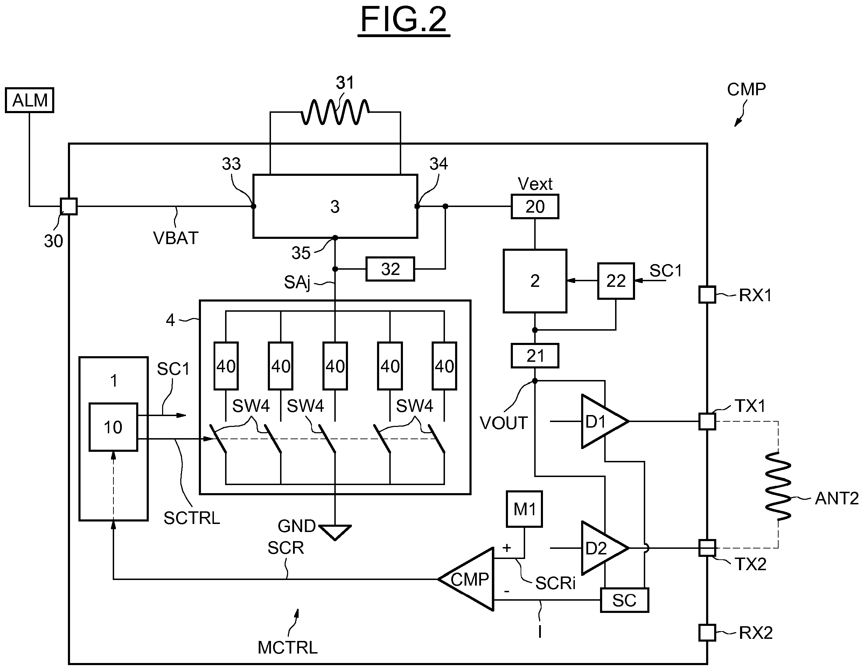

On se réfère maintenant plus particulièrement à la figure 2 pour illustrer plus en détail un exemple de structure interne de la puce CMP.

Dans cet exemple, l'antenne ANT2 est pilotée en courant par des moyens de pilotage comportant ici des circuits de pilotage (« drivers ») D1 et D2, typiquement formés d'inverseurs, dont les sorties sont connectées aux contacts TX1 et TX2 de la puce CMP.

Ces circuits de pilotage D1 et D2 sont par conséquent configurés pour délivrer en sortie un courant à destination de l'antenne.

Ces circuits de pilotage D1 et D2 sont alimentés par une tension VOUT délivrée ici par un régulateur à faible chute de tension (LDO) référencé 2.

Ce régulateur 2 possède une borne d'entrée 20 lui permettant d'être alimenté par une tension d'alimentation Vext et une borne de sortie 21 délivrant la tension VOUT. La borne d'entrée 20 forme également une borne d'alimentation des moyens de pilotage.

Le régulateur 2 permet notamment de lisser le bruit sur la tension d'alimentation Vext et présente ici une faible chute de tension, par exemple 200 millivolts.

Par ailleurs, comme on le verra plus en détail ci-après, afin de contrôler le niveau de la puissance émise par l'antenne ANT2, il est avantageusement prévu, en présence d'une requête de diminution du niveau de puissance émise, de diminuer la tension d'alimentation Vext tout en conservant une chute de tension constante dans le régulateur 2.

A cet égard, comme il est classique en la matière, il est prévu par exemple un réseau résistif 22, dont la valeur résistive est ajustable par un signal de commande SC1, permettant d'ajuster la tension de sortie VOUT du régulateur 2 de façon que la chute de tension (Vext - VOUT) reste constante.

Bien que cela ne soit pas indispensable, il est avantageusement prévu dans cet exemple de réalisation que la tension d'alimentation Vext soit délivrée par une alimentation à découpage 3 (« DC-DC converter ») programmable. L'alimentation à découpage peut être du type « montante » ou bien « montante ou descendante ».

Dans l'exemple décrit ici, l'alimentation à découpage 3 est du type montante et peut être par exemple celle commercialisée par la société STMicroelectronics sous la référence STBB3JCC.

L'alimentation à découpage 3 possède une entrée 33 destinée à recevoir une tension initiale Vbat, issue par exemple d'un moyen d'alimentation tel qu'une batterie, une sortie 34 destinée à délivrer la tension d'alimentation Vext et une entrée de commande 35 destinée à recevoir un signal d'ajustement SAJ permettant de commander l'alimentation à découpage de façon à ajuster la valeur souhaitée pour la tension d'alimentation Vext.

Selon le type d'alimentation à découpage choisie, celle-ci peut être placée à l'extérieur de la puce CMP comme c'est le cas par exemple pour l'alimentation référencée ST BB3JCC.

En variante, comme illustré sur la figure 2, il serait également possible d'adapter la structure interne de l'alimentation à découpage de façon à l'intégrer au moins partiellement dans la puce CMP.

Cela étant, en général, l'élément inductif 31 de l'alimentation à découpage reste à l'extérieur de la puce CMP.

L'alimentation à découpage permet ainsi de délivrer en particulier une tension d'alimentation Vext supérieure à la tension initiale Vbat.

Lorsque l'alimentation à découpage 3 est au moins partiellement intégrée dans la puce CMP, on peut prévoir que cette dernière comporte une borne 30 destinée à être couplée à la batterie ALM.

Le dispositif DIS de communication sans contact comporte également des moyens de contrôle MCTRL configurés pour contrôler le niveau de puissance émise par l'antenne ANT2.

Dans cet exemple, les moyens de contrôle MCTRL sont incorporés dans la puce CMP et comportent, outre les moyens de génération de la tension d'alimentation Vext (comportant ici l'alimentation à découpage 3), des moyens d'élaboration 10 permettant à partir d'un signal SCTRL d'élaborer un signal d'ajustement SAJ qui va être délivré sur l'entrée de commande 35 de l'alimentation à découpage de façon à le cas échéant, réduire la tension d'alimentation Vext.

Dans l'exemple décrit ici, ces moyens d'élaboration 10 sont par exemple réalisés de façon logicielle au sein d'un microcontrôleur 1, par exemple un microcontrôleur NFC, présent au sein de la puce CMP.

Cela étant, il serait tout à fait possible de réaliser ces moyens d'élaboration 10 de façon purement matérielle au sein de la puce CMP.

Il convient de noter ici que les moyens d'élaboration 10 peuvent également être utilisés pour générer le signal de contrôle SC1 permettant de régler le réseau résistif 22 du régulateur LDO 2 de façon à maintenir sa chute de tension constante en présence d'une diminution de la tension d'alimentation Vext.

Dans l'exemple décrit ici, une diminution de la tension Vext s'obtient en interrompant le fonctionnement de l'alimentation à découpage pendant un certain temps puis en ajustant la valeur du signal d'ajustement SAJ pour atteindre la nouvelle valeur cible de la tension Vext.

A cet égard, il est prévu un circuit résistif configurable 4 comportant un certain nombre de résistances 40, égales ou différentes, qui peuvent être commutées par des interrupteurs correspondants SW4 commandés par le signal de contrôle SCTRL, de façon à former avec la résistance 32 connectée entre la sortie 34 et l'entrée de commande 35 de l'alimentation à découpage, un pont diviseur de tension ajustable.

Bien entendu il serait possible de remplacer le réseau résistif 22 et le circuit résistif 4 par tout autre circuit de contre-réaction de contrôle, comme par exemple un circuit comportant un convertisseur numérique analogique recevant un mot numérique de contrôle et délivrant un signal analogique de contrôle sur l'entrée de contre-réaction du régulateur LDO 2 ou sur l'entrée de commande de l'alimentation à découpage.

Dans cet exemple, les moyens de contrôle MCTRL comportent également des premiers moyens de mesure SC du courant délivré en sortie des circuits de pilotage D1 et D2 ainsi qu'un premier comparateur CMP configuré pour comparer le courant mesuré avec au moins un seuil de courant SCR1 stocké dans des premiers moyens de mémoire Ml, par exemple un registre.

Le résultat de la comparaison fournit un signal SCR qui va être délivré aux moyens d'élaboration 10 de façon à élaborer le signal d'ajustement SAJ comme il va être expliqué plus en détail ci-après.

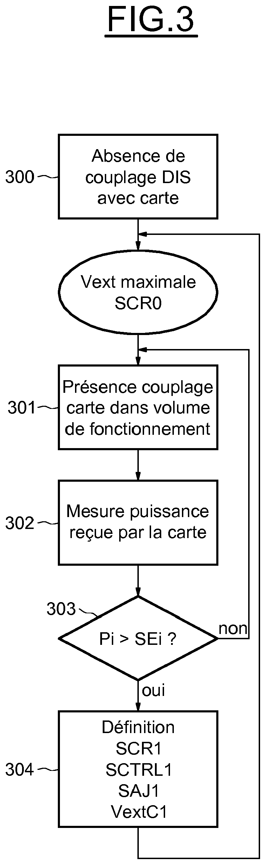

On se réfère maintenant plus particulièrement à la figure 3 pour illustrer un exemple de définition des différents seuils de courants, effectuée dans une phase d'étalonnage, permettant la gestion des requêtes de diminution de niveaux de puissance.

Cette phase d'étalonnage est effectuée classiquement en usine.

Elle débute tout d'abord dans l'étape 300, par le fonctionnement du dispositif lecteur DIS en absence de couplage avec une carte.

Dans cette situation, afin d'optimiser avantageusement le fonctionnement des lecteurs, on affecte à la tension Vext sa valeur maximale, par exemple 5 volts, et l'on mesure le courant délivré par les circuits de pilotage D1 et D2, ce qui fournit un premier seuil de courant SCR0.

En général, dans ce type d'application, la puissance émise est bien en-deçà de la valeur maximale tolérée par la norme ISO/IEC443 qui est de 7,5 A/m (rms).

Puis, on place (étape 301) une carte en couplage avec le dispositif DIS dans un volume de fonctionnement (« operating volume ») défini par la norme considérée, par exemple la norme ISO/IEC443, correspondant à différentes distances entre la carte et le lecteur.

A ces différentes distances correspondent différents niveaux de puissance maximum admissibles mesurés au niveau de la carte.

On mesure (étape 302) la puissance reçue par la carte.

Tant que le niveau de puissance Pi reçu par la carte reste inférieur à un seuil de puissance admissible SEi (étape 303) on continue à balayer le volume de fonctionnement en se rapprochant par exemple du lecteur.

Et, dès qu'à une distance donnée, le niveau de puissance mesuré au niveau de la carte Pi devient supérieur au seuil admissible SEi, on mesure le courant délivré par les circuits de pilotage ce qui permet de définir (étape 304) un premier seuil de courant supplémentaire SCR1. On définit alors la valeur du signal de contrôle SCTRL1 et la valeur SAJ1 du signal d'ajustement correspondant de façon à faire atteindre à la tension d'alimentation Vext une valeur cible VextC1 permettant de ramener le courant délivré par les circuits de pilotage entre le premier seuil de courant SCR0 et le premier seuil de courant supplémentaire SCR1.

Dans ce cas, on aura réduit le niveau de puissance délivré par le lecteur pour se conformer aux exigences de la norme.

Selon les cas, un seul seuil de courant supplémentaire peut être nécessaire.

Dans d'autres cas, on peut, lors du balayage de volume de fonctionnement (« operating volume ») définir d'autres seuils de courant supplémentaires et d'autres valeurs cibles correspondantes pour la tension d'alimentation Vext.

Et, à chaque fois, la valeur cible sera définie de façon à ramener le courant entre le premier seuil de courant SCR0 et le premier seuil de courant supplémentaire SCR1 qui est le seuil de courant supplémentaire le plus faible parmi tous les autres seuils de courants supplémentaires éventuels.

En effet, en général plus la carte va se rapprocher du lecteur, plus le courant délivré par les circuits de pilotage va augmenter.

Ainsi, à titre d'exemple, le premier seuil de courant SCR0 peut être par exemple égal à 200 milliampères tandis que le premier seuil de courant supplémentaire SCR1 peut être égal à 250 milliampères.

Les éventuels autres seuils de courant supplémentaires sont déterminés en refixant la tension d'alimentation Vext à sa valeur maximale et en rapprochant la carte du lecteur.

Cela étant il est également possible que le courant diminue lorsque la carte se rapproche du lecteur. Aussi dans ce cas on peut définir une ou plusieurs paires de seuils de courant supplémentaires, contenant chacune un seuil minimum et un seuil maximum, et on peut alors considérer que le niveau de puissance émis doit être réduit si l'un des seuils supplémentaires d'une paire est franchi.

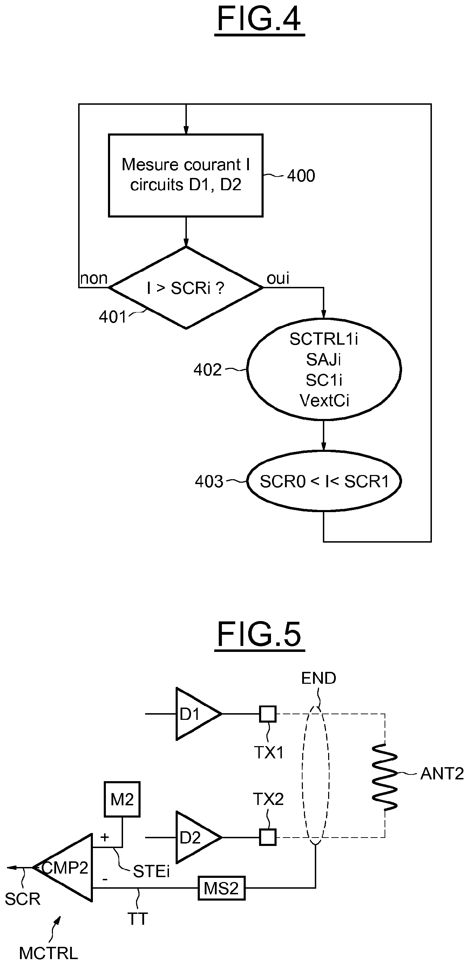

Une fois cette phase d'étalonnage effectuée, et les différents seuils de courant mémorisés dans les moyens de mémoire M1, le contrôle du niveau de puissance émise par l'antenne ANT2 du lecteur peut s'effectuer comme illustré par exemple sur la figure 4.

Plus précisément, on mesure en temps réel, lors du fonctionnement réel du lecteur couplé à la carte, le courant I délivré en sortie de circuits de pilotage D1 et D2 (étape 400).

On vérifie, dans l'étape 401, si le courant I devient supérieur à l'un des seuils de courant supplémentaires SCRi.

Dans la négative, cela signifie qu'on est en l'absence d'une requête de diminution du niveau de puissance émise par le lecteur.

Dans l'affirmative, cela signifie qu'on est en présence d'une telle requête Rq de diminution du niveau de puissance émise.

En fonction du seuil de courant supplémentaire franchi, les moyens d'élaboration élaborent (étape 402) le signal de contrôle SCTRLi, le signal d'ajustement SAJi, le signal de contrôle SC1i et la valeur cible VextCi pour la tension d'alimentation du régulateur LDO2 de façon à ramener le courant I délivré par les circuits de pilotage entre le premier seuil de courant SCR0 et le premier seuil de courant supplémentaire SCR1 (étape 403).

La diminution de la tension d'alimentation Vext à chute de tension constante dans le régulateur LDO permet de limiter la puissance consommée et donc l'échauffement par rapport à une solution prévoyant par exemple de garder la tension Vext constante et d'augmenter la chute de tension du régulateur.

En effet si l'on suppose par exemple qu'il est nécessaire de passer d'une tension VOUT de 4,8 volts à une tension VOUT de 3,3 Volts en gardant une tension Vext égale à 5 volts (la chute de tension du régulateur passe de 200 mV à 1,5 volts), la puissance consommée est de l'ordre de 490 mW (pour une résistance des circuits de pilotage égale à 1 ohm et un courant délivré égal à 250 mA).

Par contre si l'on garde la chute de tension constante égale à 200 mV et que l'on diminue la tension Vext de 5 volts à 3,5 volts, alors la puissance consommée est de l'ordre de 110 mW.

Alors que dans les modes de réalisation et de mise en œuvre qui viennent d'être décrits, on a ajusté la valeur cible de la tension d'alimentation Vext à partir du courant mesuré en sortie des circuits de pilotage, il serait possible, en variante, d'effectuer une mesure de tension et/ou de phase en un endroit END (figure 5) situé entre la sortie des circuits de pilotage et l'antenne, par exemple en amont ou en aval du circuit d'adaptation d'impédance.

On suppose dans cet exemple qu'on effectue une mesure de tension.

A cet égard, lesdits moyens de contrôle MCTRL peuvent comporter des deuxièmes moyens de mesure MS2 aptes à mesurer cette tension témoin TT et à la comparer dans un deuxième comparateur CMP2 avec au moins un seuil de tension STEi stocké dans des deuxièmes moyens de mémoire M2 tels qu'un registre.

La sortie du comparateur CMP2 délivre le signal SCR.

Les autres éléments des moyens de contrôle MCTRL sont analogues ou fonctionnellement analogues à ceux qui ont été décrits en référence à la figure 2 notamment.

D'une façon analogue à ce qui a été décrit en référence à la figure 3, on peut alors, dans une phase d'étalonnage, définir le premier seuil de tension STEO pour la tension témoin TT correspondant à la valeur maximale de la tension d'alimentation Vext et à une absence de couplage du dispositif DIS avec une carte (étape 600).

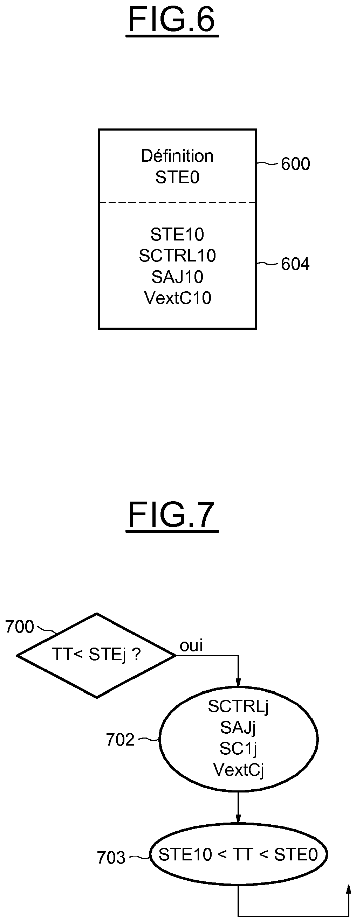

Puis, d'une façon analogue et à ce qui a été décrit en référence à la figure 3, on définit au moins un seuil de tension supplémentaire STE10, voire plusieurs seuils de tension supplémentaires et on associe à chaque seuil de tension supplémentaire, une valeur correspondante des signaux STRL10, SAJ10 et une valeur cible correspondante VextC10 pour la tension d'alimentation (étape 604 figure 6).

Cette fois-ci, lorsqu'il y a un couplage entre le dispositif et la carte, chaque seuil de tension supplémentaire est inférieur au premier seuil STEO et plus on se rapproche du dispositif DIS, plus le seuil de tension supplémentaire STEj devient faible.

Ainsi, on définira les différentes valeurs des signaux de contrôle et des valeurs cible de façon à ramener la tension témoin entre le seuil STEO et le premier seuil de tension supplémentaire le plus élevé, à savoir le seuil STE10.

Bien entendu tout ce qui vient d'être décrit pour la mesure de la tension témoin s'applique également à une mesure de phase témoin.

Il serait également possible par analogie à ce qui a été décrit pour la mesure en courant prévoyant la possibilité d'une diminution de courant lors d'un rapprochement de la carte, de définir une ou plusieurs paires de seuils de tensions et/ou de phases supplémentaires, et on peut alors considérer que le niveau de puissance émis doit être réduit si l'un des seuils de tensions et/ou de phases supplémentaires d'une paire est franchi.

Ainsi, en fonctionnement, comme illustré sur la figure 7, et par analogie à ce qui a été décrit en référence à la figure 4, dès que la tension témoin TT devient inférieure à un seuil de tension (et/ou le cas échéant de phase) supplémentaire STEj (étape 701) cela signifie que l'on est en présence d'une requête Rq de diminution du niveau de puissance émise par l'antenne.

Les moyens d'élaboration élaborent alors, dans l'étape 702, les signaux de contrôle SCTRLj, SAJj, SC1j de façon à permettre à la tension d'alimentation Vext d'atteindre sa valeur cible VextCj pour ramener la tension (et/ou le cas échéant la phase) témoin TT entre les seuils STE10 et STEO (étape 703).

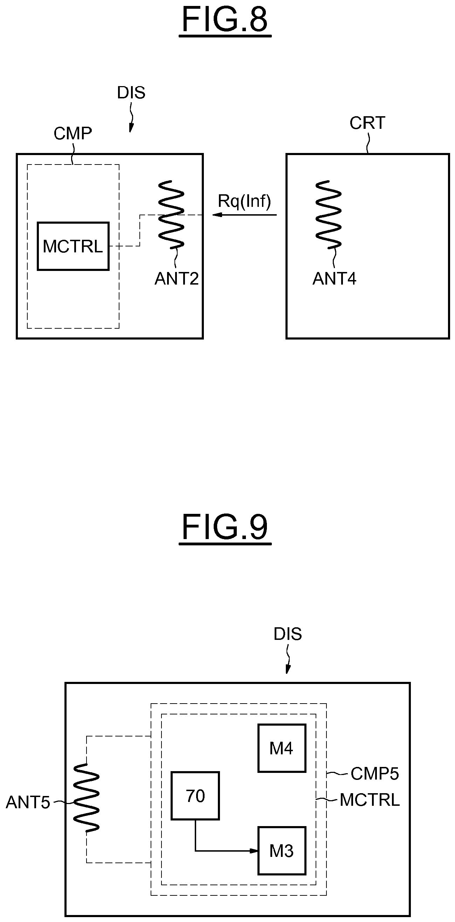

Alors que dans les modes de réalisation et de mise en œuvre qui viennent d'être décrits, la requête Rq de diminution du niveau de puissance émise est générée par le dispositif DIS lui-même, il est possible, comme illustré sur la figure 8, que cette requête Rq provienne d'une carte CRT dont l'antenne ANT4 est en couplage électromagnétique avec l'antenne ANT2 du dispositif DIS.

Ceci peut être le cas lorsque la carte CRT est capable de supporter les dispositions prévues dans l'amendement DPLM de la norme IOS/IEC 14443.

Dans ce cas, la requête Rq comporte une information Inf indiquant la diminution de niveau de puissance requise.

Cette information Inf est transmise aux moyens de contrôle MCTRL du dispositif DIS qui, d'une façon analogue et à ce qui a été décrit ci-avant, élaborent le signal d'ajustement SAJ à délivrer à l'alimentation à découpage de façon à diminuer en conséquence la tension d'alimentation Vext du régulateur LDO 2 présent dans la puce CMP.

Dans une telle variante, il serait possible d'inhiber les moyens de mesure soit en courant soit en tension et/ou phase. Cela étant, il peut être avantageux de laisser actifs ces moyens de mesure de façon à effectuer un contrôle en continu du niveau de puissance émise après traitement de la requête reçue.

Dans les modes de réalisation et de mise en œuvre qui viennent d'être décrits, le dispositif DIS de communication sans contact était un lecteur ou était émulé en mode lecteur. Cela étant, le dispositif DIS peut être également un transpondeur actif ou être émulé en mode carte et capable de communiquer avec un lecteur selon une modulation active de charge.

Un tel dispositif DIS est par exemple illustré schématiquement sur la figure 9.

On définit alors pour contrôler le niveau de puissance émis par l'antenne ANT5 du transpondeur actif DIS, plusieurs niveaux de puissance émis par cette antenne ANT5 associés à plusieurs niveaux de puissance reçus par l'antenne ANT5 du dispositif de la part du lecteur.

On détecte alors au sein du dispositif DIS, par exemple par des moyens de détection comportant un système de contrôle automatique de gains, le niveau de puissance reçu.

Une augmentation du niveau de puissance reçu correspond à la présence d'une requête de diminution du niveau de puissance émise par l'antenne ANT5 du dispositif.

En effet, si le niveau de puissance reçu par le dispositif DIS augmente, cela signifie qu'on se rapproche du lecteur et qu'en conséquence il convient de diminuer la puissance émise par l'antenne ANT5 du dispositif lors de la modulation active de charge.

Les différents niveaux de puissance à émettre par l'antenne ANT5 sont mémorisés dans des moyens de mémoire M3.

Et, les moyens de contrôle comportent des quatrièmes moyens de mémoire M4 configurés pour stocker pour chaque niveau de puissance émis, la valeur cible correspondante de ladite tension d'alimentation Vext et les moyens d'élaboration sont configurés pour ajuster la valeur du signal d'ajustement en fonction de la valeur cible correspondante de la tension d'alimentation.

En effet, les moyens de contrôle illustrés sur la figure 2, et notamment l'alimentation à découpage 3, le régulateur LDO 2 et les circuits de pilotage D1 et D2 sont incorporés également dans la puce CMP5 du dispositif formant transpondeur actif.

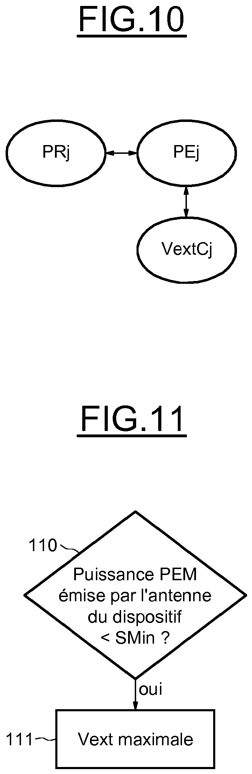

Ceci est illustré plus particulièrement sur la figure 10, sur laquelle on voit que l'on associe à chaque niveau de puissance PRj reçu par l'antenne ANT5 du transpondeur DIS, un niveau de puissance PEj à émettre par cette antenne ANT5, ainsi que la valeur cible correspondante VextCj de la tension d'alimentation du régulateur LDO.

Dans tout ce qui vient d'être décrit, le contrôle de la puissance émise par l'antenne du dispositif DIS de communication sans contact, que ce soit un lecteur ou un transpondeur actif, se traduisait par une diminution du niveau de puissance.

Cela étant, il est également possible, comme illustré schématiquement sur la figure 11, d'envisager que si la puissance PEM émise par l'antenne du dispositif devient inférieure à un seuil minimal admissible SMin, tel que par exemple le seuil de 1,5 A/m (rms) prévu par la norme ISO IEC 14443, alors les moyens de contrôle commandent l'alimentation à découpage de façon à réappliquer la valeur maximale sur la tension d'alimentation Vext du régulateur LDO2.

L'invention n'est pas limitée aux modes de mise en œuvre et de réalisation qui viennent d'être décrits mais en embrasse toutes les variantes.

Bien que l'on ait décrit ci-avant, notamment dans le cas d'un contrôle par mesure du courant en sortie des circuits de pilotage, des valeurs préenregistrées de signaux d'ajustement SAJ, il serait possible de réaliser ce contrôle par un ajustement progressif, incrémental par exemple, de façon à réaliser un rebouclage continu pour atteindre progressivement la valeur cible de la tension Vext.

On pourrait également remplacer l'alimentation à découpage 3 par un autre régulateur à chute de tension programmable ou encore par un transistor PMOS dont la source serait reliée à la tension initiale Vbat et dont le drain, délivrant la tension d'alimentation Vext, serait relié à sa grille par l'intermédiaire d'un pont diviseur de tension ajustable et d'un comparateur dont une autre entrée recevrait une tension de référence.

## Revendications

1. Procédé de contrôle du niveau de la puissance émise par une antenne d'un dispositif de communication sans contact, ladite antenne (ANT2) étant pilotée par des moyens de pilotage (2, D1, D2) alimentés par une tension d'alimentation (Vext) et configurés pour délivrer en sortie un courant à destination de l'antenne, le procédé comprenant en présence d'une requête de diminution d'un niveau actuel de ladite puissance émise, une diminution de la tension d'alimentation (Vext) des moyens de pilotage jusqu'à une valeur cible (VextC1) correspondant à un nouveau niveau cible de ladite puissance émise inférieur audit niveau actuel.

2. Procédé selon la revendication 1, dans lequel les moyens de pilotage comportent un régulateur à chute de tension (2) alimenté par ladite tension d'alimentation (Vext) et délivrant une tension de sortie (VOUT) égale à ladite tension d'alimentation diminuée de ladite chute de tension, et des circuits de pilotage (D1, D2) couplés aux bornes de l'antenne, alimentés par ladite tension de sortie et délivrant à leur sortie ledit courant, et la diminution de la tension des moyens de pilotage comprend une diminution de la tension d'alimentation du régulateur jusqu'à ladite valeur cible, ladite chute de tension étant inchangée.

3. Procédé selon l'une des revendications précédentes, dans lequel on génère la tension d'alimentation de façon ajustable à partir d'une tension initiale (VBAT) et d'un signal d'ajustement (SAJ), et la diminution de ladite tension d'alimentation comprend une élaboration dudit signal d'ajustement de façon à permettre à ladite tension d'alimentation d'atteindre sa valeur cible.

4. Procédé selon la revendication 3, dans lequel on génère la tension d'alimentation sur la sortie d'une alimentation à découpage (3) pilotable possédant une entrée recevant ladite tension initiale et une entrée de commande sur laquelle on délivre ledit signal d'ajustement.

5. Procédé selon l'une des revendications précédentes, dans lequel le dispositif de communication sans contact étant un lecteur ou étant émulé en mode lecteur, le procédé comprend une mesure du courant (I) délivré en sortie des moyens de pilotage (D1, D2), une comparaison du courant mesuré à au moins un seuil de courant (SCR1), le résultat de la comparaison correspondant soit à ladite présence de la requête de diminution de puissance émise soit à une absence de ladite requête.

6. Procédé selon la revendication 5 prise en combinaison avec la revendication 3 ou 4, dans lequel on définit un premier seuil de courant (SCRO) et au moins un seuil de courant supplémentaire (SCR1), supérieur au premier seuil (SCR0), et dont le franchissement correspond à la présence d'une requête (Rq) de diminution de niveau de puissance, et on associe à chaque seuil de courant supplémentaire une valeur du signal d'ajustement permettant à ladite tension d'alimentation d'atteindre une valeur cible conduisant à ramener le courant délivré en sortie des moyens de couplage à une valeur située entre le premier seuil de courant et le seuil de courant supplémentaire le plus faible.

7. Procédé selon l'une des revendications 1 à 4, dans lequel le dispositif de communication sans contact étant un lecteur ou étant émulé en mode lecteur, le procédé comprend une mesure d'une tension et/ou d'une phase témoin (TT) en un endroit (END) situé entre la sortie des moyens de pilotage et l'antenne, une comparaison de la tension et/ou de la phase témoin à au moins un seuil de tension et/ou de phase (STE10), le résultat de la comparaison correspondant soit à ladite présence de la requête de diminution de niveau de puissance émise soit à une absence de ladite requête.

8. Procédé selon la revendication 7 prise en combinaison avec la revendication 3 ou 4, dans lequel on définit un premier seuil de tension et/ou de phase (STEO) et au moins un seuil de tension et/ou de phase supplémentaire (STE10), inférieur au premier seuil, et dont le franchissement par la tension et/ou la phase témoin correspond à la présence d'une requête de diminution de niveau de puissance, et on associe à chaque seuil de tension et/ou de phase supplémentaire une valeur du signal d'ajustement permettant à ladite tension d'alimentation d'atteindre une valeur cible conduisant à ramener la tension et/ou la phase témoin à une valeur située entre le premier seuil de tension et/ou de phase et le seuil de tension et/ou de phase supplémentaire le plus élevé.

9. Procédé selon la revendication 6 ou 8, dans lequel le premier seuil de courant (SCRO) ou le premier seuil de tension et/ou de phase (STEO) correspond à une absence de couplage de ladite antenne avec une autre antenne d'un transpondeur sans contact.

10. Procédé selon l'une des revendications 1 à 4, dans lequel le dispositif de communication sans contact étant un transpondeur ou étant émulé en mode carte capable de communiquer avec un lecteur selon une modulation active de charge, le procédé comprend une définition de plusieurs niveaux de puissance (PEj) émis par l'antenne du dispositif associés à plusieurs niveaux de puissance (PRj) reçus par l'antenne du dispositif de la part du lecteur, une détection par le dispositif du niveau de puissance reçu, une augmentation du niveau de puissance reçu correspondant à ladite présence de la requête de diminution de niveau de puissance émise par l'antenne du dispositif.

11. Procédé selon la revendication 10, dans lequel on définit pour chaque niveau de puissance émis la valeur cible correspondante de ladite tension d'alimentation.

12. Procédé selon l'une des revendications précédentes, dans lequel ladite requête de diminution de puissance est générée par le dispositif de communication sans contact lui-même.

13. Procédé selon l'un des revendications 1 à 4, dans lequel le dispositif de communication sans contact étant un lecteur ou étant émulé en mode lecteur, la requête de diminution de puissance est communiquée au lecteur par un transpondeur ou un autre dispositif de communication émulé en mode carte couplé au lecteur et comporte une information (Inf) indiquant la valeur de la diminution requise.

14. Procédé selon la revendication 13, dans lequel à la réception de ladite requête de diminution de niveau de puissance, on génère au sein du lecteur ladite valeur cible de la tension d'alimentation.

15. Procédé selon l'une des revendications précédentes, dans lequel on définit une valeur maximale pour la tension d'alimentation correspondant à un niveau initial de puissance, et la diminution de puissance débute à partir de ladite valeur maximale de tension d'alimentation.

16. Procédé selon la revendication 15, dans lequel le niveau initial de puissance correspond à un niveau de puissance émise en absence de couplage de ladite antenne avec une autre antenne d'un autre dispositif sans contact.

17. Procédé selon la revendication 15 ou 16, dans lequel lorsque la puissance émise (PEM) atteint un seuil minimal admissible (SMin), on augmente la tension d'alimentation jusqu'à sa valeur maximale.

18. Dispositif de communication sans contact, comprenant une antenne (ANT2), des moyens de pilotage (2, D1, D2) possédant une borne d'alimentation (20) destinée à recevoir une tension d'alimentation (Vext) et configurés pour délivrer un courant à destination de l'antenne, et des moyens (MCTRL) de contrôle de la puissance émise par ladite antenne configurés pour, en présence d'une requête de diminution d'un niveau actuel de puissance émise, diminuer la tension d'alimentation (Vext) des moyens de pilotage jusqu'à une valeur cible correspondant à un nouveau niveau cible de ladite puissance émise inférieur audit niveau actuel.

19. Dispositif selon la revendication 18, dans lequel les moyens de pilotage comportent un régulateur à chute de tension (2) possédant une borne d'entrée couplée à la borne d'alimentation et configuré pour délivrer sur sa borne de sortie une tension de sortie (VOUT) égale à ladite tension d'alimentation (Vext) diminuée de ladite chute de tension, et des circuits de pilotage (D1, D2) couplés aux bornes de l'antenne, destinés à être alimentés par ladite tension de sortie et configurés pour délivrer à leur sortie ledit courant, et les moyens de contrôle sont configurés pour diminuer la tension d'alimentation du régulateur jusqu'à ladite valeur cible, ladite chute de tension étant inchangée.

20. Dispositif selon l'une des revendications 18 ou 19, dans lequel les moyens de contrôle (MCTRL) comportent des moyens de génération (3) configurés pour générer la tension d'alimentation (Vext) de façon ajustable à partir d'une tension initiale (VBAT) et d'un signal d'ajustement (SAJ), et des moyens d'élaboration (10) configurés pour élaborer le signal d'ajustement de façon à permettre à ladite tension d'alimentation d'atteindre sa valeur cible.

21. Dispositif selon la revendication 20, dans lequel les moyens de génération comportent une alimentation à découpage pilotable (3) possédant une entrée pour recevoir ladite tension initiale, une sortie pour délivrer ladite tension d'alimentation et une entrée de commande destinée à recevoir ledit signal d'ajustement.

22. Dispositif selon la revendication 21, comprenant une puce électronique (CMP) incorporant les moyens de pilotage, les moyens d'élaboration et au moins une partie de l'alimentation à découpage.

23. Dispositif selon l'une des revendications 18 à 22, étant un lecteur ou étant émulé en mode lecteur, et dans lequel les moyens de contrôle (MCTRL) comportent des premiers moyens de mesure (SC) configurés effectuer une mesure du courant délivré en sortie des moyens de pilotage, des premiers moyens de comparaison (CMP) configurés pour effectuer une comparaison du courant mesuré à au moins un seuil de courant, le résultat de la comparaison correspondant soit à ladite présence de la requête de diminution de niveau de puissance émise soit à une absence de ladite requête.

24. Dispositif selon la revendication 23 prise en combinaison avec l'une des revendications 20 à 22, dans lequel les moyens de contrôle (MCTRL) comportent des premiers moyens de mémoire (M1) configurés pour stocker un premier seuil de courant et au moins un seuil de courant supplémentaire, supérieur au premier seuil, et dont le franchissement correspond à la présence d'une requête de diminution de puissance, et les moyens d'élaboration sont configurés pour associer à chaque seuil de courant supplémentaire une valeur du signal d'ajustement permettant à ladite tension d'alimentation d'atteindre sa valeur cible de façon à ramener le courant délivré en sortie des moyens de couplage à une valeur située entre le premier seuil de courant et le seuil de courant supplémentaire le plus faible.

25. Dispositif selon l'une des revendications 18 à 22, étant un lecteur ou étant émulé en mode lecteur, les moyens de contrôle comportent des deuxièmes moyens de mesure (MS2) configurés pour effectuer une mesure d'une tension et/ou d'une phase témoin (TT) en un endroit situé entre la sortie des moyens de pilotage et l'antenne, des deuxièmes moyens de comparaison (CMP2) configurés pour effectuer une comparaison de la tension et/ou de la phase témoin à au moins un seuil de tension et/ou de phase, le résultat de la comparaison correspondant soit à ladite présence de la requête de diminution de niveau de puissance émise soit à une absence de ladite requête.

26. Dispositif selon la revendication 25 prise en combinaison avec l'une des revendications 20 à 22, dans lequel les moyens de contrôle (MCTRL) comportent des deuxièmes moyens de mémoire (M2) configurés pour stocker un premier seuil de tension et/ou de phase et au moins un seuil de tension et/ou de phase supplémentaire, inférieur au premier seuil, et dont le franchissement par la tension et/ou la phase témoin correspond à la présence d'une requête de diminution de niveau de puissance, et les moyens d'élaboration sont configurés pour associer à chaque seuil de tension et/ou de phase supplémentaire une valeur du signal d'ajustement permettant à ladite tension d'alimentation d'atteindre sa valeur cible de façon à ramener la tension et/ou la phase témoin à une valeur située entre le premier seuil de tension et/ou de phase et le seuil de tension et/ou de phase supplémentaire le plus élevé.

27. Dispositif selon la revendication 24 ou 26, dans lequel le premier seuil de courant ou le premier seuil de tension et/ou de phase correspond à une absence de couplage de ladite antenne avec une autre antenne d'un transpondeur sans contact.

28. Dispositif selon l'une des revendications 18 à 22, étant un transpondeur ou étant émulé en mode carte capable de communiquer avec un lecteur selon une modulation active de charge, les moyens de contrôle (MCTRL) comportent des troisièmes moyens de mémoire (M3) configurés pour stocker plusieurs niveaux de puissance émis par l'antenne du dispositif associés à plusieurs niveaux de puissance reçus par l'antenne du dispositif de la part du lecteur, des moyens de détection configurés pour effectuer une détection du niveau de puissance reçu, une augmentation du niveau de puissance reçu correspondant à ladite présence de la requête de diminution de niveau de puissance émise par l'antenne du dispositif.

29. Dispositif selon la revendication 28 prise en combinaison avec l'une des revendications 20 à 22, dans lequel les moyens de contrôle comportent des quatrièmes moyens de mémoire (M4) configurés pour stocker pour chaque niveau de puissance émis, la valeur cible correspondante de ladite tension d'alimentation et les moyens d'élaboration sont configurés pour ajuster la valeur du signal d'ajustement en fonction de la valeur cible correspondante de la tension d'alimentation.

30. Dispositif selon l'une des revendications 18 à 29, dans lequel les moyens de contrôle sont configurés pour générer ladite requête de diminution de niveau de puissance (Rq).

31. Dispositif selon l'un des revendications 18 à 22, étant un lecteur ou étant émulé en mode lecteur, les moyens de contrôle sont configurés pour recevoir la requête de diminution de niveau de puissance (Rq) de la part d'un transpondeur ou d'un autre dispositif de communication émulé en mode carte couplé audit dispositif, ladite requête (Rq) comportant une information (Inf) indiquant la valeur de la diminution de niveau requise.

32. Dispositif selon la revendication 31, dans lequel les moyens de contrôle sont configurés pour générer ladite valeur cible de la tension d'alimentation à la réception de ladite requête de diminution de niveau de puissance.

33. Dispositif selon l'une des revendications 18 à 32, dans lequel les moyens de contrôle sont configurés pour débuter une diminution de niveau de puissance à partir d'une valeur maximale pour la tension d'alimentation correspondant à un niveau initial de puissance.

34. Dispositif selon la revendication 33, dans lequel le niveau initial de puissance correspond à un niveau de puissance émise en absence de couplage de ladite antenne avec une autre antenne d'un autre dispositif sans contact.

35. Dispositif selon la revendication 33 ou 34, dans lequel lorsque la puissance émise (PEM) atteint un seuil minimal admissible (SMin), les moyens de contrôle (MCTRL) sont configurés pour augmenter la tension d'alimentation jusqu'à sa valeur maximale.

36. Appareil hôte incorporant un dispositif de communication sans contact (DIS) selon l'une des revendications 18 à 35.

## Patentansprüche

1. Verfahren zur Kontrolle des Pegels der von einer Antenne einer kontaktlosen Kommunikationsvorrichtung gelieferten Leistung, wobei die Antenne (ANT2) durch Steuereinrichtungen (2, D1, D2) gesteuert wird, die von einer Versorgungsspannung (Vext) gespeist werden und konfiguriert sind, um Strom an die Antenne zu übertragen, wobei das Verfahren bei Vorhandensein einer Aufforderung zur Reduzierung eines aktuellen Leistungspegels eine Reduzierung der Versorgungsspannung (Vext) der Steuereinrichtungen auf einen Zielwert (VextC1) umfasst, der einem neuen Zielpegel der gelieferten Leistung entspricht, der niedriger als der aktuelle Pegel ist.

2. Verfahren nach Anspruch 1, bei dem die Steuereinrichtungen einen Spannungsabfallregler (2) umfassen, der von der Versorgungsspannung (Vext) gespeist wird und eine Ausgangsspannung (VOUT) überträgt, die der um den Spannungsabfall reduzierten Versorgungsspannung entspricht, und Steuerschaltungen (D1, D2), die mit den Antennenanschlüssen vernetzt sind, die durch die Ausgangsspannung gespeist werden und an ihrem Ausgang den Strom übertragen, und die Reduzierung der Spannung der Steuereinrichtungen umfasst eine Reduzierung der Versorgungsspannung des Reglers auf den Zielwert, wobei der Spannungsabfall unverändert bleibt.

3. Verfahren nach einem der vorhergehenden Ansprüche, bei dem die Versorgungsspannung einstellbar aus einer Anfangsspannung (VBAT) und einem Einstellsignal (SAJ) erzeugt wird, und das Reduzierung dieser Versorgungsspannung eine Erstellung des Einstellsignals umfasst, um zu ermöglichen, dass die Versorgungsspannung ihren Zielwert erreicht.

4. Verfahren nach Anspruch 3, bei dem die Versorgungsspannung am Ausgang eines steuerbaren Schaltnetzteils (3) erzeugt wird, der einen die Anfangsspannung empfangenden Eingang besitzt und einen Steuereingang, an den das Einstellsignal übertragen wird.

5. Verfahren nach einem der vorhergehenden Ansprüche, bei dem die kontaktlose Kommunikationsvorrichtung ein Lesegerät ist oder im Lesemodus emuliert ist; das Verfahren umfasst eine Messung des am Ausgang der Steuereinrichtungen (D1, D2) übertragenen Stroms (I) und einen Vergleich des gemessenen Stroms mit mindestens einem Stromschwellenwert (SCR1), wobei das Ergebnis des Vergleichs entweder dem Vorhandensein der Aufforderung zur Reduzierung der gelieferten Leistung entspricht oder einem Fehlen der Aufforderung.

6. Verfahren nach Anspruch 5 in Kombination mit Anspruch 3 oder 4, bei dem ein erster Stromschwellenwert (SCRO) und mindestens ein zusätzlicher Stromschwellenwert (SCR1), der größer als der erste Schwellenwert (SCRO) ist, definiert werden und von denen die Überschreitung dem Vorhandensein einer Aufforderung (Rq) zur Reduzierung des Leistungspegels entspricht, und jeder zusätzliche Stromschwellenwert wird einem Wert des Einstellsignals zugeordnet, was der Versorgungsspannung ermöglicht, einen Zielwert zu erreichen, der den am Ausgang der Verbindungsmittel übertragenen Strom auf einen Wert zurückstellt, der zwischen dem ersten Stromschwellenwert und dem niedrigsten zusätzlichen Stromschwellenwert liegt.

7. Verfahren nach einem der Ansprüche 1 bis 4, bei dem die kontaktlose Kommunikationsvorrichtung ein Lesegerät ist oder im Lesemodus emuliert ist; das Verfahren umfasst eine Messung einer Spannung und/oder einer Indikatorphase (TT) an einer Stelle (END), die zwischen dem Ausgang der Steuereinrichtungen und der Antenne liegt, und einen Vergleich der Spannung und/oder der Indikatorphase mit mindestens einem Spannungs- und/oder Phasenschwellenwert (STE10), wobei das Ergebnis des Vergleichs entweder dem Vorhandensein der Aufforderung zur Reduzierung des gelieferten Leistungspegels entspricht oder einem Fehlen der Aufforderung.

8. Verfahren nach Anspruch 7 in Kombination mit Anspruch 3 oder 4, bei dem ein erster Spannungs- und/oder Phasenschwellenwert (STEO) und mindestens ein zusätzlicher Spannungs- und/oder Phasenschwellenwert (STE10), der niedriger ist, als der erste Schwellenwert, definiert werden und deren Überschreitung durch die Spannung und/oder die Indikatorphase dem Vorhandensein einer Aufforderung zur Reduzierung des Leistungspegels entspricht, und ein Wert des Einstellsignals ist jedem zusätzlichen Spannungs- und/oder Phasenschwellenwert zugeordnet, der der Versorgungsspannung ermöglicht, einen Zielwert zu erreichen, der dazu führt, die Spannung und/oder die Indikatorphase auf einen Wert zurückzustellen, der zwischen dem ersten Spannungs- und/oder Phasenschwellenwert und dem höchsten zusätzlichen Spannungs- und/oder Phasenschwellenwert liegt.

9. Verfahren nach Anspruch 6 oder 8, bei dem der erste Stromschwellenwert (SCRO) oder der erste Spannungs- und/oder Phasenschwellenwert (STEO) einem Fehlen der Verbindung der Antenne mit einer anderen Antenne eines kontaktlosen Transponders entspricht.

10. Verfahren nach einem der Ansprüche 1 bis 4, wobei die kontaktlose Kommunikationsvorrichtung ein Transponder ist oder im Kartenmodus emuliert ist und mit einem Lesegerät gemäß einer aktiven Lastmodulation kommunizieren kann; das Verfahren umfasst eine Definition mehrerer Leistungspegel (PEj), geliefert von der Antenne der Vorrichtung, die mehreren Leistungspegeln (PRj) zugeordnet ist, die von der Antenne der Vorrichtung des Lesegeräts empfangen werden, eine Erfassung des empfangenen Leistungspegels durch die Vorrichtung und eine Erhöhung des empfangenen Leistungspegels, die dem Vorhandensein der Aufforderung zur Reduzierung des von der Antenne der Vorrichtung gelieferten Leistungspegels entspricht.

11. Verfahren nach Anspruch 10, bei dem der entsprechende Zielwert der Versorgungsspannung für jeden gelieferten Leistungspegel definiert wird.

12. Verfahren nach einem der vorhergehenden Ansprüche, wobei die Aufforderung zur Leistungsreduzierung durch die kontaktlose Kommunikationsvorrichtung selbst erzeugt wird.

13. Verfahren nach einem der Ansprüche 1 bis 4, bei dem die kontaktlose Kommunikationsvorrichtung ein Lesegerät ist oder im Lesemodus emuliert ist; die Aufforderung zur Leistungsreduzierung wird dem Lesegerät durch einen Transponder oder eine andere im Kartenmodus emulierte Kommunikationsvorrichtung übermittelt, die mit dem Lesegerät vernetzt ist und eine Information (Inf) aufweist, die den Wert der erforderlichen Reduzierung angibt.

14. Verfahren nach Anspruch 13, wobei beim Empfang der Aufforderung zur Reduzierung des Leistungspegels der Zielwert der Versorgungsspannung innerhalb des Lesegeräts erzeugt wird.

15. Verfahren nach einem der vorhergehenden Ansprüche, bei dem ein Höchstwert für die Versorgungsspannung definiert wird, der einem Anfangsleistungspegel entspricht, und die Leistungsabnahme beginnt bei diesem Höchstwert der Versorgungsspannung.

16. Verfahren nach Anspruch 15, bei dem der Anfangsleistungspegel einem Leistungspegel entspricht, der ohne die Verbindung der Antenne mit einer anderen Antenne einer anderen kontaktlosen Vorrichtung geliefert wird.

17. Verfahren nach Anspruch 15 oder 16, bei dem bei Erreichen eines minimalen zulässigen Schwellenwerts (SMin) der gelieferten Leistung (PEM) die Versorgungsspannung auf ihren Höchstwert erhöht wird.

18. Kontaktlose Kommunikationsvorrichtung, umfassend eine Antenne (ANT2) und Steuereinrichtungen (2, D1, D2), die einen Versorgungsanschluss (20) besitzen, der dazu bestimmt ist, eine Versorgungsspannung (Vext) zu empfangen und konfiguriert ist, um einen für die Antenne bestimmten Strom zu übertragen, und Kontrolleinrichtungen (MCTRL) für die von der Antenne gelieferten Leistung, die konfiguriert sind, um, bei Vorhandensein einer Aufforderung zur Reduzierung eines aktuellen Leistungspegels, die Versorgungsspannung (Vext) der Steuereinrichtungen auf einen Zielwert zu reduzieren, der einem neuen Zielpegel der gelieferten Leistung entspricht, der niedriger als der aktuelle Pegel ist.

19. Vorrichtung nach Anspruch 18, bei der die Steuereinrichtungen einen Spannungsabfallregler (2) umfassen, der einen Eingangsanschluss besitzt, der mit dem Versorgungsanschluss vernetzt ist und konfiguriert, um an seinem Ausgangsanschluss eine Ausgangsspannung zu übertragen (VOUT), die identisch mit der Versorgungsspannung (Vext) ist, die durch den Spannungsabfall reduziert wurde, und Steuerschaltungen (D1, D2), die mit den Antennenanschlüssen gekoppelt sind, dazu bestimmt, von der Ausgangsspannung gespeist zu werden, und konfiguriert, um an ihrem Ausgang den Strom zu übertragen, und die Kontrolleinrichtungen sind konfiguriert, um die Versorgungsspannung des Reglers auf den Zielwert zu reduzieren, wobei der Spannungsabfall unverändert bleibt.

20. Vorrichtung nach einem der Ansprüche 18 oder 19, bei der die Kontrolleinrichtungen (MCTRL) Erzeugungseinrichtungen (3) umfassen, die konfiguriert sind, um die Versorgungsspannung (Vext) einstellbar aus einer Anfangsspannung (VBAT) und einem Einstellsignal (SAJ) zu erzeugen und Entwicklungseinrichtungen (10), die so konfiguriert sind, dass sie das Einstellsignal erzeugen, um es der Versorgungsspannung zu ermöglichen, ihren Zielwert zu erreichen.

21. Vorrichtung nach Anspruch 20, bei der die Erzeugungseinrichtungen ein steuerbares Schaltnetzteil (3) umfassen, das einen Eingang zum Empfangen der Anfangsspannung, einen Ausgang zum Übertragen der Versorgungsspannung und einen Steuereingang zum Empfangen des Einstellsignals besitzt.

22. Vorrichtung nach Anspruch 21, umfassend einen elektronischen Chip (CMP), der die Steuereinrichtungen, die Entwicklungseinrichtungen und zumindest einen Teil des Schaltnetzteils einbezieht.

23. Vorrichtung nach einem der Ansprüche 18 bis 22, die ein Lesegerät ist oder im Lesemodus emuliert ist, und bei der die Kontrolleinrichtungen (MCTRL) erste Messeinrichtungen (SC) umfassen, die konfiguriert sind, um eine Messung des am Ausgangs der Steuereinrichtungen übertragenen Stroms durchzuführen, und erste Vergleichseinrichtungen (CMP), die konfiguriert sind, um einen Vergleich des gemessenen Stroms mit mindestens einem Stromschwellenwert durchzuführen, wobei das Ergebnis des Vergleichs entweder dem Vorhandensein der Aufforderung zur Reduzierung des gelieferten Leistungspegels entspricht oder einem Fehlen der Aufforderung.

24. Vorrichtung nach Anspruch 23 in Kombination mit einem der Ansprüche 20 bis 22, bei der die Kontrolleinrichtungen (MCTRL) erste Speichereinrichtungen (M1) umfassen, die konfiguriert sind, um einen ersten Stromschwellenwert und mindestens einen zusätzlichen Stromschwellenwert zu speichern, der größer als der erste Schwellwert ist, und dessen Überschreitung dem Vorhandensein einer Aufforderung zur Leistungsreduzierung entspricht, und die Entwicklungseinrichtungen sind konfiguriert, um jedem zusätzlichen Stromschwellenwert einen Wert des Einstellsignals zuzuordnen, der es der Versorgungsspannung ermöglicht, ihren Zielwert zu erreichen, um den am Ausgang der Verbindungsmittel übertragenen Strom auf einen Wert zurückzustellen, der zwischen dem ersten Stromschwellenwert und dem niedrigsten zusätzlichen Stromschwellenwert liegt.

25. Vorrichtung nach einem der Ansprüche 18 bis 22, die ein Lesegerät ist oder im Lesemodus emuliert ist, wobei die Kontrolleinrichtungen zweite Messeinrichtungen (MS2) umfassen, die konfiguriert sind, um eine Messung einer Spannung und/oder einer Indikatorphase (TT) an einem Ort durchzuführen, der sich zwischen dem Ausgang der Steuereinrichtungen und der Antenne befindet, und den zweiten Vergleichseinrichtungen (CMP2), die konfiguriert sind, um einen Vergleich der Spannung und/oder der Indikatorphase mit mindestens einem Spannungs- und/oder Phasenschwellenwert durchzuführen; das Ergebnis des Vergleichs entspricht entweder dem Vorhandensein der Aufforderung zur Reduzierung des gelieferten Leistungspegels oder einem Fehlen der Aufforderung.

26. Vorrichtung nach Anspruch 25 in Kombination mit einem der Ansprüche 20 bis 22, bei der die Kontrolleinrichtungen (MCTRL) zweite Speichereinrichtungen (M2) umfassen, die konfiguriert sind, um einen ersten Spannungs- und/oder Phasenschwellenwert und mindestens einen zusätzlichen Spannungs- und/oder Phasenschwellenwert zu speichern, der niedriger als der erste Schwellenwert ist, und dessen Überschreitung durch die Spannung und/oder die Indikatorphase dem Vorhandensein einer Aufforderung zur Reduzierung des Leistungspegels entspricht, und die Entwicklungseinrichtungen sind konfiguriert, um jedem zusätzlichen Spannungs- und/oder Phasenschwellenwert einen Wert des Einstellsignals zuzuordnen, der es der Versorgungsspannung ermöglicht, ihren Zielwert zu erreichen, um die Spannung und/oder die Indikatorphase wieder auf einen Wert zurückzustellen, der zwischen dem ersten Spannungs- und/oder Phasenschwellenwert liegt und dem höchsten zusätzlichen Spannungs- und/oder Phasenschwellenwert.

27. Vorrichtung nach Anspruch 24 oder 26, bei der der erste Stromschwellenwert oder der erste Spannungs- und/oder Phasenschwellenwert einem Fehlen der Verbindung der Antenne mit einer anderen Antenne eines kontaktlosen Transponders entspricht.

28. Vorrichtung nach einem der Ansprüche 18 bis 22, die ein Transponder ist oder im Kartenmodus emuliert ist und mit einem Lesegerät gemäß einer aktiven Lastmodulation kommunizieren kann; die Kontrolleinrichtungen (MCTRL) umfassen dritte Speichereinrichtungen (M3), die konfiguriert sind, um mehrere von der Antenne der Vorrichtung emittierte Leistungspegel zu speichern, die mehreren Leistungspegeln zugeordnet sind, die von der Antenne der Vorrichtung vom Lesegerät empfangen werden, und Erfassungseinrichtungen, die zum Erfassen des empfangenen Leistungspegels konfiguriert sind; eine Erhöhung des empfangenen Leistungspegels entspricht dem Vorhandensein der Aufforderung zur Reduzierung des von der Antenne der Vorrichtung gelieferten Leistungspegels.

29. Vorrichtung nach Anspruch 28 in Kombination mit einem der Ansprüche 20 bis 22, bei der die Kontrolleinrichtungen vierte Speichereinrichtungen (M4) umfassen, die konfiguriert sind, um für jeden übertragenen Leistungspegel den entsprechenden Zielwert der Versorgungsspannung zu speichern, und die Entwicklungseinrichtungen sind konfiguriert, um den Wert des Einstellsignals in Abhängigkeit des entsprechenden Zielwerts der Versorgungsspannung anzupassen.

30. Vorrichtung nach einem der Ansprüche 18 bis 29, bei der die Kontrolleinrichtungen konfiguriert sind, um die Aufforderung zur Reduzierung des Leistungspegels (Rq) zu erzeugen.

31. Vorrichtung nach einem der Ansprüche 18 bis 22, die ein Lesegerät ist oder im Lesemodus emuliert ist, wobei die Kontrolleinrichtungen konfiguriert sind, um die Aufforderung zur Reduzierung des Leistungspegels (Rq) von einem Transponder oder von einer anderen im Kartenmodus emulierten Kommunikationsvorrichtung, die mit der Vorrichtung vernetzt ist, zu empfangen, wobei die Aufforderung (Rq) eine Information (Inf) aufweist, die den Wert der erforderlichen Pegelreduzierung angibt.

32. Vorrichtung nach Anspruch 31, wobei die Kontrolleinrichtungen konfiguriert sind, um den Zielwert der Versorgungsspannung bei Empfang der Aufforderung zur Reduzierung des Leistungspegels zu erzeugen.

33. Vorrichtung nach einem der Ansprüche 18 bis 32, bei der die Kontrolleinrichtungen konfiguriert sind, um eine Reduzierung des Leistungspegels ausgehend von einem Höchstwert der Versorgungsspannung, die einem Anfangsleistungspegel entspricht, zu starten.

34. Vorrichtung nach Anspruch 33, bei der der Anfangsleistungspegel einem Leistungspegel entspricht, der ohne die Verbindung der Antenne mit einer anderen Antenne einer anderen kontaktlosen Vorrichtung geliefert wird.

35. Vorrichtung nach Anspruch 33 oder 34, bei der die Kontrolleinrichtungen (MCTRL) konfiguriert sind, um die Versorgungsspannung auf ihren Höchstwert zu erhöhen, wenn die gelieferte Leistung (PEM) einen minimal zulässige Schwellenwert (SMin) erreicht.

36. Hostgerät mit einer kontaktlosen Kommunikationsvorrichtung (DIS) nach einem der Ansprüche 18 bis 35.

## Claims

1. A method for monitoring the level of the power emitted by an antenna of a contactless communication device, said antenna (ANT2) being controlled by control means (2, D1, D2) powered by a supply voltage (Vext) and configured to output a current to the antenna, the method comprising, in the presence of a request for reducing a current level of said emitted power, a reduction of the supply voltage (Vext) of the control means up to a target value (VextC1) corresponding to a new target level of said emitted power lower than said current level.

2. The method according to claim 1, wherein the control means include a dropout voltage regulator (2) powered by said supply voltage (Vext) and outputting an output voltage (VOUT) equal to said supply voltage reduced by said voltage drop, and control circuit (D1, D2) coupled to the terminals of the antenna, powered by said output voltage and outputting said current at the output thereof, and the reduction of the voltage of the control means comprises a reduction of the supply voltage of the regulator down to said target value, said voltage drop being unchanged.

3. The method according to one of the preceding claims, wherein the supply voltage is generated in an adjustable manner from an initial voltage (VBAT) and from an adjustment signal (SAJ), and the reduction of said supply voltage comprises an elaboration of said adjustment signal so as to enable said supply voltage to reach its target value.

4. The method according to claim 3, wherein the supply voltage is generated on the output of a controllable switched-mode power supply (3) having an input receiving said initial voltage and a control input on which said adjustment signal is delivered.

5. The method according to one of the preceding claims, wherein the contactless communication device being a reader or being emulated in reader mode, the method comprises a measurement of the current (I) output by the control means (D1, D2), a comparison of the measured current with at least one current threshold (SCR1), the result of the comparison corresponding either to said presence of the emitted power reduction request or to an absence of said request.

6. The method according to claim 5 considered in combination with claim 3 or 4, wherein a first current threshold (SCRO) and at least one additional current threshold (SCR1), higher than the first threshold (SCR0), and which crossing thereof corresponds to the presence of a power level reduction request (Rq) are defined, and a value of the adjustment signal, enabling said supply voltage to reach a target value leading to the current output being brought by the coupling means to a value located between the first current threshold and the lowest additional current threshold, is associated to each additional current threshold.

7. The method according to one of claims 1 to 4, wherein the contactless communication device being a reader or being emulated in reader mode, the method comprises a measurement of a comparative voltage and/or phase (TT) at a location (END) located between the output of the control means and the antenna, a comparison of the comparative voltage and/or phase with at least one voltage and/or phase threshold (STE10), the result of the comparison corresponding either to said presence of the emitted power level reduction request or a to an absence of said request.

8. The method according to claim 7 considered in combination with claim 3 or 4, wherein a first voltage and/or phase threshold (STE0) and at least one additional voltage and/or phase threshold (STE10), lower than the first threshold, and which crossing thereof by the comparative voltage and/or phase corresponds to the presence of a power level reduction request, and a value of the adjustment signal, enabling said supply voltage to reach a target value leading to the comparative voltage and/or phase being brought to a value located between the first voltage and/or phase threshold and the highest additional voltage and/or phase threshold, is associated to each additional voltage and/or phase threshold.

9. The method according to claim 6 or 8, wherein the first current threshold (SCR0) or the first voltage and/or phase threshold (STE0) corresponds to an absence of coupling of said antenna with another antenna of a contactless transponder.

10. The method according to one of claims 1 to 4, wherein the contactless communication device being a transponder or being emulated in card mode capable of communicating with a reader according to an active load modulation, the method comprises a definition of several power levels (PEj) emitted by the antenna of the device associated to several power levels (PRj) received by the antenna of the device from the reader, a detection by the device of the received power level, an increase of the received power level corresponding to said presence of the request for reducing the level of power emitted by the antenna of the device.

11. The method according to claim 10, wherein the corresponding target value of said supply voltage is defined for each emitted power level.

12. The method according to one of the preceding claims, wherein said power reduction request is generated by the contactless communication device itself.

13. The method according to one of claims 1 to 4, wherein the contactless communication device being a reader or being emulated in reader mode, the power reduction request is communicated to the reader by a transponder or another communication device emulated in card mode coupled to the reader and includes a piece of information (Inf) indicating the value of the requested reduction.

14. The method according to claim 13, wherein upon receiving said power level reduction request, said target value of the supply voltage is generated within the reader.

15. The method according to one of the preceding claims, wherein a maximum value is defined for the supply voltage corresponding to an initial power level, and the power reduction starts from said supply voltage maximum value.

16. The method according to claim 15, wherein the initial power level corresponds to a level of power emitted in the absence of coupling of said antenna with another antenna of another contactless device.

17. The method according to claim 15 or 16, wherein when the emitted power (PEM) reaches a minimum acceptable threshold (SMin), the supply voltage is increased up to its maximum value.

18. A contactless communication device, comprising an antenna (ANT2), control means (2, D1, D2) having a power supply terminal (20) intended to receive a supply voltage (Vext) and configured to deliver a current to the antenna, and means (MCTRL) for monitoring the power emitted by said antenna configured, in the presence of a request for reducing a current emitted power level, to reduce the supply voltage (Vext) of the control means down to a target value corresponding to a new target level of said emitted power lower than said current level.

19. The device according to claim 18, wherein the control means include a dropout voltage regulator (2) having an input terminal coupled to the power terminal and configured to deliver on its output terminal an output voltage (VOUT) equal to said supply voltage (Vext) reduced by said voltage drop, and control circuits (D1, D2) coupled to the terminals of the antenna, intended to be powered by said output voltage and configured to deliver said current at the output thereof, and the monitoring means are configured to reduce the supply voltage of the regulator down to said target value, said voltage drop being unchanged.

20. The device according to one of claims 18 or 19, wherein the monitoring means (MCTRL) include generation means (3) configured to generate the supply voltage (Vext) in an adjustable manner from an initial voltage (VBAT) and from an adjustment signal (SAJ), and elaboration means (10) configured to elaborate the adjustment signal so as to enable said supply voltage to reach its target value.

21. The device according to claim 20, wherein the generation means include a controllable switched-mode power supply (3) having an input to receive said initial voltage, an output to deliver said supply voltage and a control input intended to receive said adjustment signal.

22. The device according to claim 21, comprising an electronic chip (CMP) embedding the control means the elaboration means and at least one portion of the switched-mode power supply.

23. The device according to one of claims 18 to 22, being a reader or being emulated in reader mode, and wherein the monitoring means (MCTRL) include first measuring means (SC) configured to perform a measurement of the current output by the pilot means, first comparison means (CMP) configured to perform a comparison of the measured current with at least one current threshold, the result of the comparison corresponding either to said presence of the emitted power level reduction request or to an absence of said request.

24. The device according to claim 23 considered in combination with one of claims 20 to 22, wherein the monitoring means (MCTRL) include first memory means (M1) configured to store a first current threshold and at least one additional current threshold higher than the first threshold, and which crossing thereof corresponds to the presence of a power reduction request, and the elaboration means are configured to associate to each additional current threshold a value of the adjustment signal enabling said supply voltage to reach its target value so as to bring the current output by the coupling means to a value located between the first current threshold and the lowest additional current threshold.

25. The device according to one of claims 18 to 22, being a reader or being emulated in reader mode, the monitoring means include second measuring means (MS2) configured to perform a measurement of a comparative voltage and/or phase (TT) at a location located between the output of the control means and the antenna, second comparison means (CMP2) configured to perform a comparison of the comparative voltage and/or phase with at least one voltage and/or phase threshold, the result of the comparison corresponding either to said presence of the emitted power level reduction request or to an absence of said request.

26. The device according to claim 25 considered in combination with one of claims 20 to 22, wherein the monitoring means (MCTRL) include second memory means (M2) configured to store a first voltage and/or phase threshold and at least one additional voltage and/or phase threshold, lower than the first threshold, and which crossing thereof by the comparative voltage and/or phase corresponds to the presence of a power level reduction request, and the elaboration means are configured to associate to each additional voltage and/or phase threshold a value of the adjustment signal enabling said supply voltage to reach its target value so as to bring the comparative voltage and/or phase to a value located between the first voltage and/or phase threshold and the highest additional voltage and/or phase threshold.

27. The device according to claim 24 or 26, wherein the first current threshold or the first voltage and/or phase threshold corresponds to an absence of coupling of said antenna with another antenna of a contactless transponder.

28. The device according to one of claims 18 to 22, being a transponder or being emulated in card mode capable of communicating with a reader according to an active load modulation, the monitoring means (MCTRL) include third memory means (M3) configured to store several power levels emitted by the antenna of the device associated to several power levels received by the antenna of the device from the reader, detection means configured to perform a detection of the received power level, an increase of the received power level corresponding to said presence of the request for reducing the level of power emitted by the antenna of the device.

29. The device according to claim 28 considered in combination with one of claims 20 to 22, wherein the monitoring means include fourth memory means (M4) configured to store for each emitted power level, the corresponding target value of said supply voltage and the elaboration means are configured to adjust the value of the adjustment signal according to the corresponding target value of the supply voltage.

30. The device according to one of claims 18 to 29, wherein the monitoring means are configured to generate said power level reduction request (Rq).

31. The device according to one of claims 18 to 22, being a reader or being emulated in reader mode, the monitoring means are configured to receive the power level reduction request (Rq) from a transponder or from another communication device emulated in card mode coupled to said device, said request (Rq) including a piece of information (Inf) indicating the value of the required level reduction.

32. The device according to claim 31, wherein the monitoring means are configured to generate said target value of the supply voltage upon receiving said power level reduction request.

33. The device according to one of claims 18 to 32, wherein the monitoring means are configured to start a power level reduction from a maximum value for the supply voltage corresponding to an initial power level.

34. The device according to claim 33, wherein the initial power level corresponds to a level of power emitted in the absence of coupling of said antenna with another antenna of another contactless device.

35. The device according to claim 33 or 34, wherein when the emitted power (PEM) reaches a minimum acceptable threshold (SMin), the monitoring means (MCTRL) are configured to increase the supply voltage up to its maximum value.

36. A host apparatus embedding a contactless communication device (DIS) according to one of claims 18 to 35.
